Europäisches Patentamt

European Patent Office

Office européen des brevets

(19)

(11) **EP 0 365 690 B1**

(12) **EUROPEAN PATENT SPECIFICATION**

(45) Date of publication and mention
of the grant of the patent:
**22.12.1999 Bulletin 1999/51**

(21) Application number: **89905206.2**

(22) Date of filing: **25.04.1989**

(51) Int Cl.⁶: **H01L 27/04**, H01L 27/10

(86) International application number:
**PCT/JP89/00433**

(87) International publication number:
**WO 89/11162 (16.11.1989 Gazette 1989/27)**

(54) **SEMICONDUCTOR DEVICE AND SEMICONDUCTOR MEMORY DEVICE**

HALBLEITERANORDNUNG UND HALBLEITER-SPEICHERANORDNUNG

DISPOSITIF A SEMI-CONDUCTEURS ET MEMOIRE A SEMI-CONDUCTEURS

(84) Designated Contracting States:
**DE FR GB NL**

(30) Priority: **07.05.1988 JP 11103288**
**11.05.1988 JP 11523188**
**21.10.1988 JP 26530388**
**07.12.1988 JP 30912788**
**07.12.1988 JP 30912888**

(43) Date of publication of application:
**02.05.1990 Bulletin 1990/18**

(73) Proprietor: **SEIKO EPSON CORPORATION**
**Shinjuku-ku Tokyo (JP)**

(72) Inventor: **KIMURA, Masakazu**
**Suwa-shi Nagano-ken 392 (JP)**

(74) Representative: **Sturt, Clifford Mark et al**
**Miller Sturt Kenyon**
**9 John Street**
**London WC1N 2ES (GB)**

(56) References cited:
**EP-A- 0 087 979** **EP-A- 0 173 245**
**JP-A- 62 112 362** **JP-A- 62 169 472**
**JP-A- 63 016 658** **US-A- 4 679 171**

## Description

### Technical Field

The present invention is generally directed to a structure of a resistance element of a semiconductor device as well as to a static RAM (Random Access Memory), and more particularly, to effective techniques applied to the structure of the resistance element.

### Background Arts

In the sector of integrated circuits, techniques associated with resistance elements become more and more important as the integration thereof is improved.

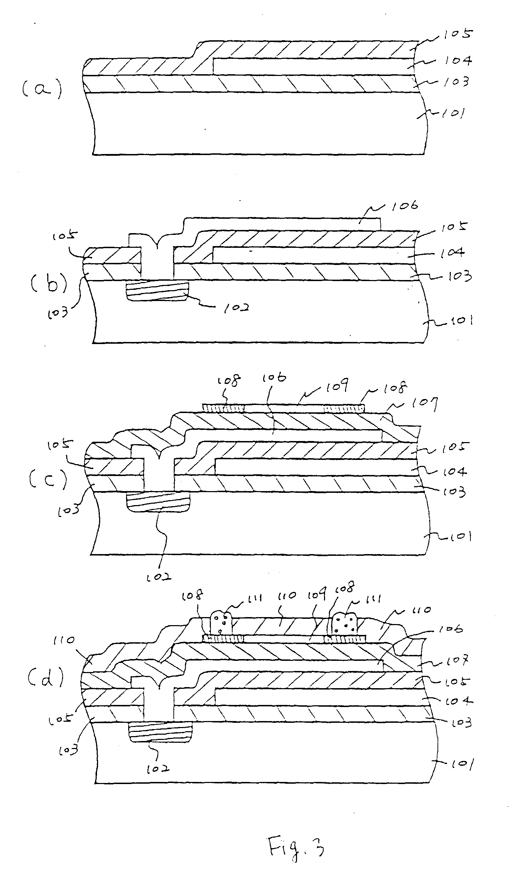

A resistance element structure of a prior art semiconductor device is that, as illustrated in FIG. 2, a low resistance region 108, serving as a wiring, into which impurities such as phosphorus and boron are implanted and a high resistance region 109 containing no or a slight amount of impurities are formed together with an element (e.g., a wiring) 104 thereunder, with only an insulating film being sandwiched therebetween.

A dominant memory cell of a conventional static RAM may be a high resistance polycrystalline silicon load type memory cell (e.g., Japanese Patent Laid-Open Publication No.57-130461). As depicted in FIG. 7, the high resistance polycrystalline silicon load type memory cell incorporates a flip-flop for storing information, the arrangement being such that one inverter is composed of a MOSFET $Q_1$ and a high resistance polycrystalline silicon resistance (high resistance region) $R_1$, the other inverter is composed of a MOSFET $Q_2$ and a high resistance polycrystalline silicon resistance (high resistance region) $R_2$, and an output of one inverter is connected to an input of the other inverter. The flip-flop is combined with switching MOSFETs Q3 and Q4 for transferring or receiving pieces information to or from a unit outside the cell. A power supply $V_{DD}$ is connected to one ends of the high resistance polycrystalline silicon resistances $R_1$ and $R_2$, while sources of the MOSFETs $Q_1$ and $Q_2$ are respectively earthed. A word line WL is connected to gates of the switching MOSFETs $Q_3$ and $Q_4$, while data lines DL and $\overline{DL}$ are connected to drains thereof.

The high resistance polycrystalline silicon resistances $R_1$ and $R_2$ are formed, for instance, in the following manner. Formed on a semiconductor substrate are the MOSFETs $Q_1$ through $Q_4$ in which a first layer, i.e., a polycide film serves as a gate. Subsequently, an inter-layer insulating film is formed, and thereafter a non-doped, viz., intrinsic polycrystalline silicon film is formed over a surface of this inter-layer insulating film. A surface of a region including a portion which will hereinafter become a high resistance polycrystalline silicon resistance (high resistance region) in the intrinsic polycrystalline silicon film is covered with a mask layer by which the phosphorus is diffused into the polycrystalline silicon film, or alternatively ion implantation is effected thereinto. The resistance is thus reduced in value. The next process is to eliminate the mask layer, and the polycrystalline silicon film undergoes patterning to assume a predetermined configuration, thereby forming a wiring consisting of an N+ type polycrystalline silicon film exhibiting a low resistivity due to the introduction of phosphorus and also high resistance polycrystalline silicon resistances $R_1$ and $R_2$ each consisting of an intrinsic polycrystalline silicon film.

However, the following problems inherent in the foregoing conventional techniques arise. There will now be made some examinations about an increase and a decrease in a consumption current $I_{DDS}$ (flowing from the power supply $V_{DD}$ to an earthing conductor via $R_1$ or $R_2$ during a so-called standby period) during the standby period (standby current) in the static RAM including the above-described high resistance polycrystalline silicon load type memory cell.

In the case of, e.g., a 256KSRAM or a 1MSRAM, the consumption current $I_{DDS}$ is typically some 1 μA, and a potential difference between $V_{DD}$ and $V_{SS}$ is approximately 5V.

Reducing the consumption current $I_{DD}$ may merely require a step of decreasing a film thickness of each of the high resistance polycrystalline silicon resistances $R_1$ and $R_2$. This implies that resistance values of the resistances $R_1$ and $R_2$ increase. The resistances, however, tend to receive an influence of an electric field of the element disposed thereunder as the film thickness is reduced. Thus, a so-called polycrystalline silicon thin film transistor structure is developed, wherein the wiring layer serves as source and drain regions, the high resistance polycrystalline silicon resistances $R_1$ and $R_2$ are conceived as substrates, and the element provided downwardly is a gate electrode. It therefore follows that the resistance values of the high resistance polycrystalline silicon resistances $R_1$ and $R_2$ vary (referred to as a TFT effect) depending on a state of the electric field of the element thereunder. This approach is a technique disclosed in Jpn. J. Appl. Phys. 23 (1984) L819 & 24 (1985) L4345, written by Hayashi, Noguchi and Ohshima.

Hence, it is difficult to manufacture a thin film silicon resistance element having a high resistance value with stability on the basis of the conventional techniques. This difficulty in turn causes such a problem that a high resistance polycrystalline silicon load type static RAM exhibiting characteristics of a low and stable consumption current $I_{DDS}$ is hard to be manufactured.

Accordingly, it is a primary object of the present invention, which is devised to obviate the foregoing problems, to provide a thin film silicon resistance element having a stable resistance value, and further a structure of a static RAM having a low and stable consumption current $I_{DDS}$.

JP-A-62169472 discloses a SRAM in which a conductive layer is provided, partially covering a semi-

3 EP 0 365 690 B1 4

conductor resistance element.

Thus, according to a first aspect of the present invention there is provided a semiconductor device as defined in claim 1.

In a second aspect, the invention provides a semiconductor memory as defined in claim 4.

Based on the constructions given above, a resistance element made of polycrystalline silicon constituting the high resistance region is subjected to no influence of electric fields of active and passive elements under the resistance element. It is therefore possible, as advantages of the invention, to obtain a remarkably stable and reliable semiconductor device and also a semiconductor memory exhibiting characteristics of a low and stable consumption current $I_{DDS}$.

Brief Description of the Drawings

FIG. 1 is a principal sectional view depicting a semiconductor device not covered by the present invention;

FIG. 2 is a sectional view illustrating a prior art semiconductor device;

FIGS. 3(a) through 3(d) are principal sectional views of assistance in explaining the steps of manufacturing a semiconductor device not covered by the present invention;

FIG. 4(a) is a principal plan view illustrating one embodiment of a semiconductor memory of the invention;

FIG. 4(b) is a sectional view taken substantially along the line B-$\overline{B}$, showing one embodiment of the semiconductor memory thereof;

FIGS. 5(a) through 5(c) are principal sectional views of assistance in explaining the steps in sequence as one example of a method of manufacturing the semiconductor memory of the invention which is depicted in FIGS. 4(a) and 4(b);

FIG. 6 is a principal plan view showing a variant form of the semiconductor memory of the invention;

FIG. 7 is a circuit diagram depicting a circuitry of a high resistance polycrystalline silicon load type memory cell;

FIG. 8 is a principal sectional view showing an embodiment of the semiconductor device not covered by the invention;

FIG. 9 is a principal sectional view showing another embodiment of the semiconductor memory of the invention; and

FIG. 10 is a principal sectional view showing a semiconductor memory not covered by the invention.

101... substrate
102... impurity diffusing layer
103... first insulating film
104... downward element (e.g., wiring)
105... second insulating film
106... conductive layer
106'... second conductive layer
107... third insulating film
108... low resistance region
109... high resistance region
110... fourth insulating film
110... aluminum wiring
112... fifth insulating film
$Q_1$ - $Q_4$... MOSFET
$R_1$, $R_2$... high resistance
$V_{DD}$... power supply
WL. . . word line
DL... data line
$\overline{DL}$... data line
1... semiconductor substrate
2... field insulating film
3... channel stopper
4... gate insulating film
5... polycrystalline silicon film
6... refractory silicide film
7... gate electrode
8... gate electrode
9... source region
10... drain region
11... side wall insulating film
12... inter-layer insulating film
13... conductive layer
14... second inter-layer insulating film
15... wiring layer
16... contact hole
17... third inter-layer insulating film
18... polycrystalline silicon film
19... contact hole
20... intrinsic polycrystalline silicon film
21... contact hole
22... contact hole
23... contact hole for connecting gate electrode to drain region
24... fourth inter-layer insulating film
25... second conductive layer.

Best Mode for Carrying out the Invention

A high resistance stated in embodiments of the present invention is a value of 100 G$\Omega$ or more, viz., approximately 100 G (giga)$\Omega$ to 5T (tera)$\Omega$. A potential difference between $V_{DD}$ and $V_{SS}$ in a 256KSRAM or a 1MSRAM is typically 5V, and a standby consumption current $I_{DDS}$ is preferably 1 $\mu$A or thereabouts. For this reason, a resistance value of a resistance composed of high resistance polycrystalline silicon or the like in the 256KSRAM is desirably 1T$\Omega$n, while that in the 1MSRAN is desirably 5T$\Omega$. A resistance value of a resistance in a 64KSRAM desirably falls within a range of 100 G$\Omega$ to 3000 G$\Omega$.

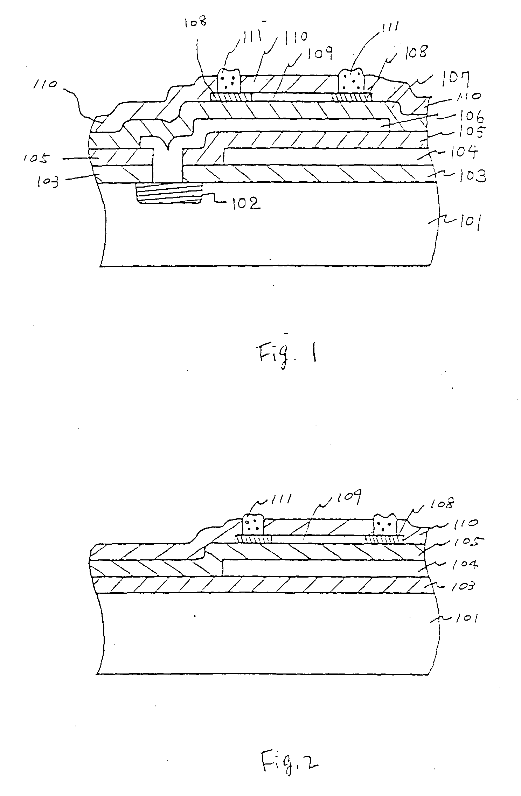

Turning first to FIG. 1, there is illustrated a sectional view of a semiconductor device not covered by the present invention.

The reference numeral 101 represents a substrate; 102 an impurity diffusing layer of the substrate; 103 a first insulating film for separating the substrate from an element disposed thereunder; 104 the downward element, i.e., a wiring ; 105 a second insulating film; 106 a conductive layer composed of polycrystalline silicon; 107 a third insulating film; 108 a low resistance region (wiring) of a low resistance element; 109 a high resistance region defined as a resistor of the resistance element; 110 a fourth insulating film; and 111 an aluminum wiring for connecting the resistance element to other elements. Note that the impurity diffusing layer 102 is earthed.

The arrangement of figure 1 will hereinafter be described in detail on the basis of the manufacturing steps with reference to FIGS. 3(a) to 3(d).

To start with, as illustrated in FIG. 3(a), the wiring 104 is formed via the first insulating film 103 on the substrate 101. A second insulating film 105 is formed on the wiring 104 as well as on the first insulating film 103. It is to be noted that the substrate 101 is earthed.

Next, as depicted in FIG. 3(b), a contact hole is perforated for connection to the substrate 101. A resist is formed on a portion other than the perforated part. Subsequently, immersion in a diluted hydrofluoric acid liquid is effected, and the first and second insulating films 103 and 105 are selectively removed by etching, thus eliminating the resist. Then, impurity ions are implanted thereinto to reduce a contact resistance. There are implanted impurities, having the same conductivity as that of the substrate 101, which may be phosphorus or arsenic if the substrate 101 is of an N-type and boron if classified as a P-type. The impurity diffusing layer 102 is thus formed. In this case, an adequate acceleration energy is 60 KeV, and a proper dose is $6 \times 10^{15} cm^{-2}$. Preparatory to formation of the conductive layer 106, the first polycrystalline silicon layer is formed to have a thickness of 400 nm (4000 Å, 1 nm = 10Å). A general practice is that a monosilane gas is thermally decomposed at 620°C, and the conductive layer 106 formed of the first polycrystalline silicon layer is deposited on the second insulating film 105. For making it conductive, first impurity ions are implanted thereinto. The impurities are, as in the previous case, made to exhibit the same conductivity as that of the substrate 101. Implantation with a dose of preferably $5 \times 10^{15} cm^{-2}$ is effected to considerably reduce the resistance value. Unnecessary portions of the conductive layer 106 are removed by photoetching.

As depicted in FIG. 3(c), a silicon oxide film (the third insulating film 107) of 2000Å is formed on the conductive layer 106 by chemical vapor growth. With a view to forming a resistance element, a second polycrystalline silicon layer is shaped in the manner identical with that in the previous case. A film thickness corresponds to a resistance value required. The second polycrystalline silicon layer into which normally no impurity is implanted is employed as the high resistance region 109. In this case, even if the impurities are more or less introduced thereinto, the high resistance region can be obtained. Formed on the high resistance region 109 is a resist which in turn serves as a mask when second impurity ions are implanted to shape the low resistance region 108. In this case, the impurities like phosphorus are implanted properly under such conditions that a dose is $4 \times 10^{15} cm^{-2}$, and an energy is 30 KeV. Thereafter, the resist is eliminated, and portions unnecessary for the resistance element are removed by effecting a photoetching process.

The fourth insulating film 110 is, as illustrated in FIG. 3(d), formed to have a thickness of 300 nm (3000Å, 1 nm = 10Å) in the manner identical with that of the third insulating film 107. To activate the impurities, annealing is effected in a nitrogen atmosphere for 20 minutes at 950°C. Finally, an aluminum wiring 111 is provided for connection with other elements. A contact hole is perforated in a part of the fourth insulating film 110 disposed on the low resistance region 108 by photoetching. The aluminum layer 111 of 1 μm is formed by sputtering. In the wake of this step, unnecessary portions of the aluminum layer 111 are removed by photoetching, whereby the resistance element depicted in FIG. 3(d) is completely manufactured. The description has dealt with a case where the substrate 101 is earthed. The substrate 101 may, however, be connected to an impurity diffusing layer formed thereon to have a conductivity different from that of a substrate earthed. Besides, the conductive layer 106 may be connected directly to an outside earth terminal, i.e., to a constant potential such as $V_{DD}$ and $V_{SS}$. The polycrystalline silicon resistance element has been stated so far, but a monocrystalline silicon resistance element monocrystallized by laser-annealing the polycrystalline silicon may be employed. The conductive layer is earthed but may be connected to a constant voltage. In this case also, the resistance value can be stabilized.

The described arrangements have employed a polycrystalline silicon layer serving as the conductive layer 106 into which the impurities are implanted. There may also be used aluminum and other refractory metals such as molybdenum (mo), titanium (Ti) and tungsten (W). In addition, refractory metal silicides of the above-mentioned, which include $MoSi_2$, $TiSi_2$, $WSi_2$ and the like, may also be employed. Namely, the materials are not limited to the silicon and metals but may be anything conductive. This may be true in other embodiments.

Disposed on the high resistance region is a second conductive layer 106' which is brought into a constant-voltage state via the insulating film 110 to thereby undergo no influence of an electric field of the element disposed on the high resistance region. As a result, the resistance element is more stabilized.

Conductive layers may be provided upwardly and downwardly of the resistance element through the insulating films.

Note that the conductive layers are not necessarily disposed under or above all the high resistance regions.

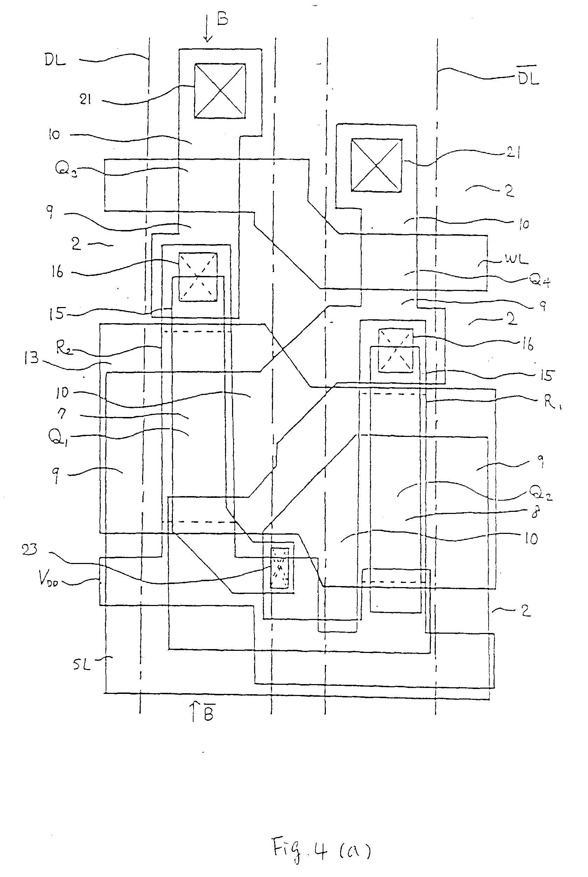

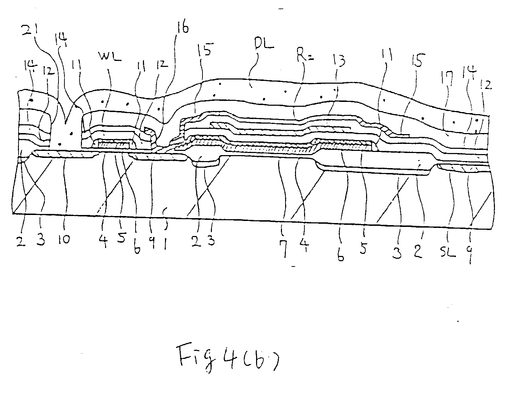

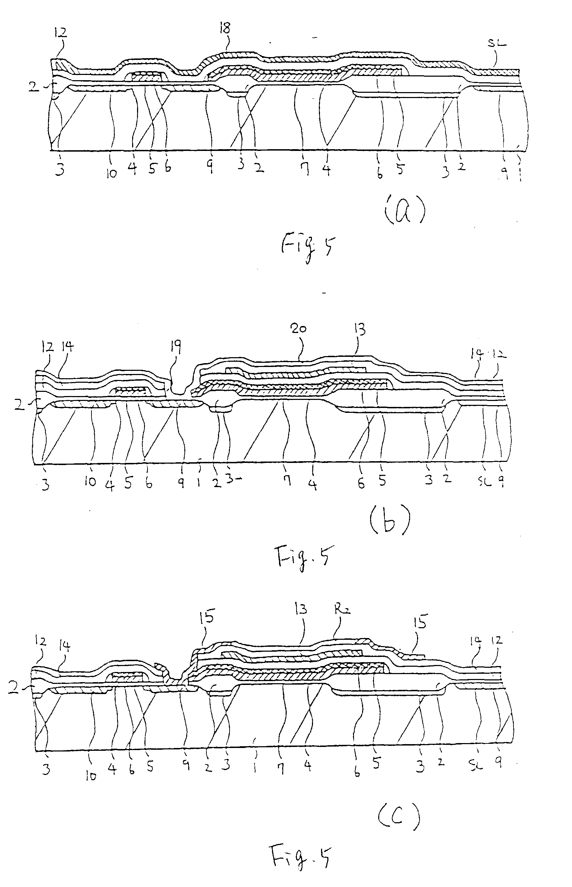

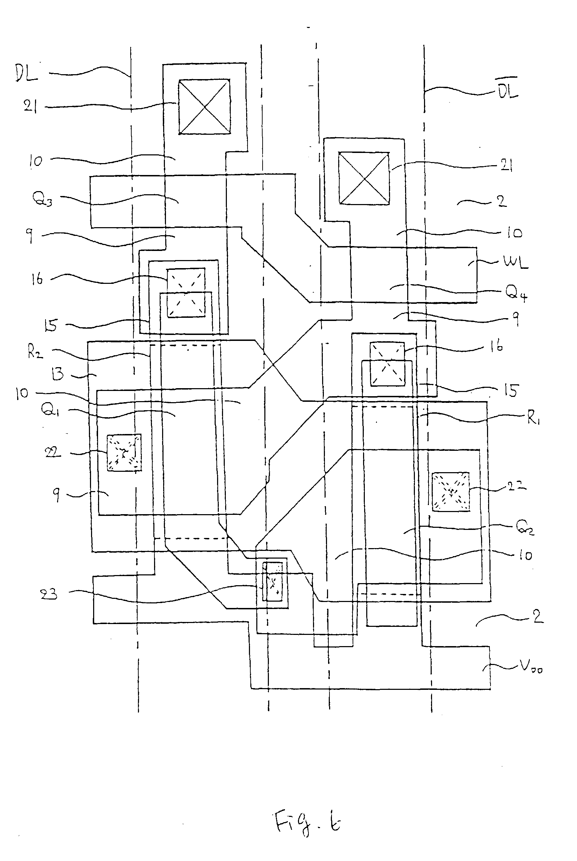

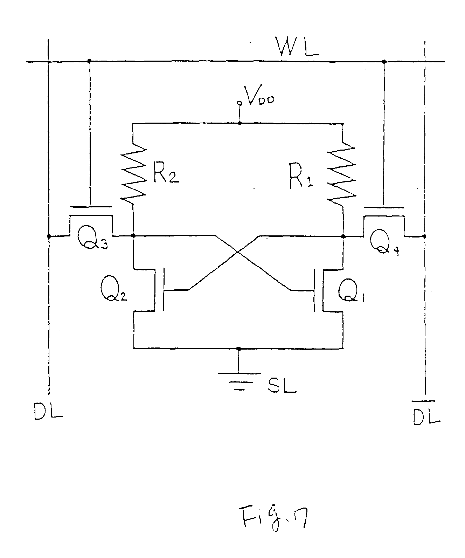

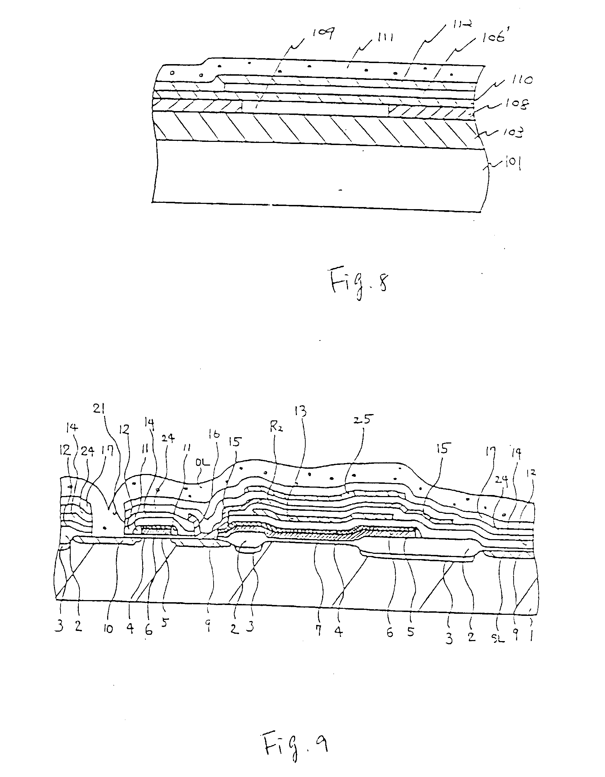

FIG. 4(a) is a plan view showing an embodiment in which the present invention is applied to a semiconductor memory. FIG. 4(b) is a sectional view taken substantially along the line B-B' of FIG. 4(a).

Throughout the drawings in the embodiments of the invention, the components having the same functions are identified by the like symbols, and the repetitive descriptions thereof are omitted herein. A memory cell of the static RAM in this embodiment has a circuitry similar to that shown in FIG. 7.

The static RAM in this embodiment requires separation of an element by use of a field insulating film 2 like, e.g., an $SiO_2$ film formed on the surface of the semiconductor substrate 1 such as a P-type silicon substrate. Provided beneath the field insulating film 2 is a P-type channel stopper region 3, thereby preventing generation of a parasitic channel.

Gate insulating films 4 like, for instance, an SiO2 film are deposited on individual surfaces of active regions surrounded by the field insulating films 2. Provided on the gate insulating film 4 and on the field insulating film 2 are a word line WL, gate electrodes 7 and 8 and an earthing conductor (source line) SL each composed of a polycide film, viz., a double-layered film consisting of, e.g., a polycrystalline silicon film 5 and a refractory metal silicide film 6 of Mo, Ti and W containing Si. An N-type source region 9 and drain region 10 are formed in the respective active regions defined by the field insulating films 2 in a self-matching manner with respect to the word line WL, the gate electrodes 7 and 8 and the earthing conductor SL. The word line W1, the source region 9 and the drain region 10 are combined to constitute switching MOSFETs $Q_3$ and $Q_4$. The gate electrode 7, the drain region 10 and the source region 9 are combined to form a MOSFET $Q_1$. The gate electrode 8, the source region 9 and the drain region 10 cooperate to constitute a MOSFET $Q_2$. The drain region 10 of the MOSFET $Q_1$ is common to the source region 9 of the MOSFET $Q_4$. These MOSFETs $Q_1$ to $Q_4$ are all based on a so-called LDD (Lightly Doped Drain) structure. The source region 9 and the drain region 10 are formed by implanting the impurities into the semiconductor substrate 1, which involves two steps, i.e., a pre-step and a post-step, of forming side wall insulating films 11 each composed of, e.g., $SiO_2$ on side surfaces of the gate electrodes 7 and 8 and the word line WL.

Formed on the MOSFETs $Q_1$ through $Q_4$ are inter-layer insulating films 12, like an $SiO_2$ film, on which to dispose a conductive layer 13, composed of a polycrystalline silicon film and earthed or connected to a constant potential to shield the electric fields of the gate electrodes 7 and 8, into which the impurities are implanted with a high concentration. The conductive layer 13 is connected to, for example, $V_{DD}$ or $V_{SS}$. Provided on the conductive layer 13 is a second inter-layer insulating film 14, like an $SiO_2$ film, on which to dispose a wiring layer 15 formed of an $N^+$ type polycrystalline silicon film assuming a predetermined configuration and high resistance polycrystalline silicon resistances $R_1$ and $R_2$ each consisting of an intrinsic polycrystalline silicon film and connected to the wiring layer 15. The wiring layer 15 comes in contact with the source regions 9 of the MOSFETs $Q_3$ and $Q_4$ via the contact holes 16 bored in the gate insulating film 4, the second inter-layer insulating film 14 and the inter-layer insulating film 12.

In this manner, the polycrystalline silicon film 13 into which the impurities are implanted with a high concentration are formed under the high resistance polycrystalline silicon resistances $R_1$ and $R_2$ through the second inter-layer insulating film 14 to thereby undergo no influence of the electric fields given from the gate electrodes 7 and 8 of the MOSFETs $Q_1$ and $Q_2$. Even if the high resistance polycrystalline silicon resistances $R_1$ and $R_2$ decrease in the film thickness, the TFT effects do not develop. Hence, stable and high resistance values can be obtained, which in turn leads to a reduction in the consumption current $I_{DDS}$.

Based on the prior arts, the high resistance polycrystalline silicon resistances $R_1$ and $R_2$ have to be 4 to 5 μm in length in order to acquire sufficient resistance values. In accordance with the embodiment of the present invention, however, the high resistance polycrystalline silicon resistances $R_1$ and $R_2$ can be reduced down to, e.g., 2 through 4 μm in length because of the increment in the resistance values in combination with thinning of the high resistance polycrystalline silicon resistances $R_1$ and $R_2$.

As a result, an area of the memory cell can be reduced in -proportion to the above-mentioned decrease in length, thereby incrementing a density of integration.

The static RAM in this embodiment involves the use of the third inter-layer insulating film 17 such as a PSG film to cover the wiring layer 15 and the high resistance polycrystalline silicon resistances $R_1$ and $R_2$. Disposed on the third inter-layer insulating film 17 are data lines DL and $\overline{DL}$ each consisting of an aluminum film or an aluminum alloy film.

Incidentally, whether or not a slight amount of impurities are implanted in the high resistance polycrystalline silicon resistances $R_1$ and $R_2$ is of no importance on condition that they exhibit high resistance values.

The description will next be focused on a method of manufacturing the static RAM in the foregoing embodiment. Referring first to FIGS. 4(a) and 4(b), there are formed the MOSFETs $Q_1$ through $Q_4$, the word line WL and the earthing conductor SL (a diffused layer of the substrate in this embodiment) over which the inter-layer insulating film 12 is disposed. Thereafter, a polycrystalline silicon film 18 of, e.g., 1000Å is formed. Subsequent to this step, the impurities such as phosphorus and boron are diffused; or alternatively the ion implantation with a high concentration of, e.g., $5 \times 10^{15}$cm$^{-2}$

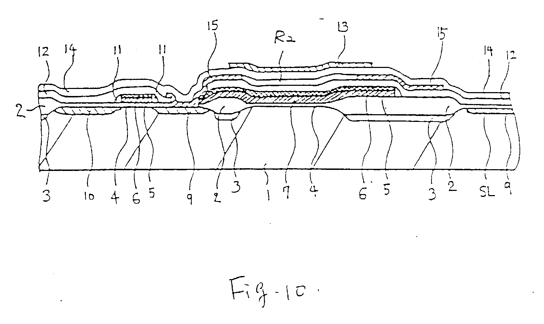

takes place therein. The polycrystalline silicon film 18 is thus made conductive (FIG. 5(a)).

Next, as illustrated in FIG. 5(b), the polycrystalline film 18 is subjected to patterning to assume a predetermined shape, thereby obtaining the conductive layer 13. Note that the conductive layer 13 is wire-arranged to be earthed or connected to a constant potential.

The second inter-layer insulating film 14 is formed over the surface, and a contact hole 19 is perforated therein. Provided on the second inter-layer insulating film 14 is an intrinsic polycrystalline film 20 having a relatively small thickness of approximately 500Å.

Subsequently, as depicted in FIG. 5(c), mask layers (not shown) each composed of a resist or $SiO_2$ is disposed on portions corresponding to the high resistance polycrystalline silicon resistances, which are formed afterwards in the intrinsic polycrystalline silicon film 20. In this state, the phosphorus diffusion or the ion implantation is effected, thereby decreasing resistance values of portions of the polycrystalline silicon film 20 which are not covered with the resist mask layer. The wiring layer 15 is thus obtained.

After removing the resist mask layer, the polycrystalline silicon film 20 undergoes patterning to take a predetermined shape, with the result that the wiring layer 15 and the high resistance polycrystalline silicon resistances $R_1$ and $R_2$ (only the resistance $R_2$ is illustrated in FIG. 5(c)) are formed. Thereafter, as depicted in FIGS. 4(a) and 4(b), a third inter-layer insulating film 17, a contact hole 21 and data lines DL and $\overline{DL}$ are formed to completely manufacture a desired static RAM.

This embodiment also involves the use of the polycrystalline silicon as a high resistance region into which virtually no or a small amount of impurities are implanted. Instead, however, monocrystalline silicon monocrystallized by laser-annealing the polycrystalline silicon may be employed as a high resistance region.

Based on the manufacturing method discussed above, it is possible to manufacture the stable static RAM having a small consumption current $I_{DDS}$ by performing the simple processes.

Although the invention made by the present inventor has been discussed so far on the basis of the illustrative embodiments in a specific manner, it is to be understood that the present invention is not limited to those embodiments. A variety of modifications may, as a matter of course, be effected therein without departing from the scope of the invention.

Sources of the MOSFETs $Q_1$ and $Q_2$ are, as depicted in FIG. 6, connected via a contact 22 to the polycrystalline silicon 15 into which the impurities are implanted with a high concentration, thus providing an earthing conductor SL for the memory cell. In this case, the memory cell earthing conductor SL which has hitherto been formed on the substrate becomes unnecessary, and hence the memory cell decreases in size enough to obtain a hyperfine structure.

The conductive layers 13 are formed downwardly of the high resistance polycrystalline silicon resistances $R_1$ and $R_2$ via the second inter-layer insulating film 14. However, the layers 13 are not necessarily provided on all the portions under the resistances $R_1$ and $R_2$.

A second conductive layer 25 having a constant voltage is, as illustrated in FIG. 9, formed via a fourth insulating film 24 on the high resistance polycrystalline silicon resistances $R_1$ and $R_2$ to thereby undergo no influence of electric fields given from the data lines DL and $\overline{DL}$. It is therefore feasible to stabilize the resistance values more effectively.

The conductive layer 13 is, as depicted in FIG. 10, provided via the second inter-layer insulating film 14 on the high resistance polycrystalline silicon resistance $R_2$ alone.

In accordance with the present invention, as discussed above, the conductive layer earthed or connected to the constant potential via the insulating film is formed downwardly of the high resistance regions of the silicon resistance element, as a result of which no influence of the electric field of the lower element exerts. Hence, the following typical advantages are obtained.

(1) It is possible to manufacture a resistance element having stable resistance values and undergoing no influence of the electric fields of other elements provided thereunder.

(2) The resistance element having a variety of resistance values can be produced because of receiving no influence of the electric fields of other elements thereunder even when varying the thickness of the silicon resistance element.

(3) The static RAM exhibiting characteristics of a low and stable consumption current $I_{DDS}$ can be attained, and the hyperfine structure can thereby be provided.

**Claims**

1. A semiconductor device comprising:

a transistor formed on a semiconductor substrate (1), the transistor having a gate (7); a first insulating film (12) formed over the transistor; a conductive layer (13) formed on said first insulating film and connected to a source adapted to provide a constant potential; a second insulating film (14) formed on said conductive layer; and a polycrystalline or monocrystalline silicon film (20) formed on said second insulating film and including two regions, a low resistance region (15) serving as a wiring and a high resistance region serving as a resistor (R2) characterised in that the conductive layer (13) is disposed substantially below the high resistance region (R2) between the high resistance region and the said gate (7) and covers a greater area than the high resistance region so as to totally shield the high resistance region from field effects of the transistor disposed below the conductive layer.

2. The semiconductor device as set forth in claim 1, characterised in that said conductive layer (13) is composed of one or more than two substances among aluminium, polycrystalline silicon and refractory metals such as Mo, Ti and W or refractory metal silicides.

3. The semiconductor device as set forth in claim 1, characterised in that said conductive layer (13) is earthed.

4. A semiconductor memory comprising:
a memory cell including a load element including high resistance polycrystalline silicon and comprising a semiconductor device as claimed in claim 1.

5. The semiconductor memory as set forth in claim 4, including a further conductive layer (25) connected to a constant potential disposed on the opposite side of the resistance (R2) to the semiconductor substrate and including an insulating film (24) disposed between said further conductive layer and said high resistance.

6. The semiconductor memory as set forth in claims 4 or 5, characterised in that said conductive layer (13) or layers (13, 25) are composed of one or more than two substances among aluminium, polycrystalline silicon and refractory metals such as Mo, Ti and W or refractory metal silicides.

7. The semiconductor memory as set forth in claims 4, 5 or 6, characterised in that said conductive layer (13) or layers (13, 25) are earthed.

8. The semiconductor memory as set forth in claims 4, 5, 6, or 7, characterised in that said conductive layer (13) or layers (13, 25) serve as an earthing conductor for said high resistance polycrystalline silicon load type memory cell.

**Patentansprüche**

1. Halbleiterbauelement umfassend

einen an einem Halbleitersubstrat (1) ausgebildeten Transistor, wobei der Transistor ein Gate (7) aufweist;

einen ersten isolierenden Film (12), der über dem Transistor ausgebildet ist;

eine leitfähige Schicht (13), die auf dem ersten isolierenden Film ausgebildet ist und mit einer zum Liefern eines konstanten Potentials geeigneten Quelle verbunden ist;

einen zweiten isolierenden Film (14), der auf der leitfähigen Schicht ausgebildet ist; und

einen polykristallinen oder monokristallinen Siliziumfilm (20), der auf dem zweiten isolierenden Film ausgebildet ist und zwei Bereiche aufweist, einen als Verdrahtung dienenden Niedrigwiderstandbereich (15) sowie einen als ein Widerstand (R2) dienender Hochwiderstandbereich, dadurch gekennzeichnet, daß die leitfähige Schicht (13) im wesentlichen unter dem Hochwiderstandbereich (R2) zwischen dem Hochwiderstandbereich und dem Gate (7) angeordnet ist und ein Gebiet überdeckt, welches größer ist als der Hochwiderstandbereich, so daß der Hochwiderstandbereich von Feldeffekten des unter der leitfähigen Schicht angeordneten Transistors ganz abgeschirmt ist.

2. Halbleiterbauelement nach Anspruch 1, dadurch gekennzeichnet, daß die leitfähige Schicht (13) aus einer oder mehr als zwei Substanzen von Aluminium, polykristallinem Silizium und hochschmelzenden Metallen wie Mo, Ti und W oder hochschmelzenden Metallsiliziden zusammengesetzt ist.

3. Halbleiterbauelement nach Anspruch 1, dadurch gekennzeichnet, daß die leitfähige Schicht (13) an Masse gelegt ist.

4. Halbleiterspeicher umfassend
eine Speicherzelle mit einem Lade/Lastelement, welches polykristallines Hochwiderstandsilizium aufweist, und mit einem Halbleiterbauelement nach Anspruch 1.

5. Halbleiterspeicher nach Anspruch 4, umfassend eine weitere, mit einem konstanten Potential verbundene leitfähige Schicht (25), die auf der zu dem Halbleitersubstrat entgegengesetzten Seite des Widerstands (R2) angeordnet ist und einen zwischen der weiteren leitfähigen Schicht und dem hohen Widerstand angeordneten, isolierenden Film (24) aufweist.

6. Halbleiterspeicher nach Anspruch 4 oder 5, dadurch gekennzeichnet, daß die leitfähige Schicht (13) oder die Schichten (13, 25) aus einem oder mehr als zwei Substanzen von Aluminium, polykristallinem Silizium und hochschmelzenden Metallen wie Mo, Ti und W oder hochschmelzenden Metallsiliziden zusammengesetzt ist.

7. Halbleiterspeicher nach Anspruch 4, 5 oder 6, dadurch gekennzeichnet, daß die leitfähige Schicht (13) oder Schichten (13, 25) an Masse gelegt sind.

8. Halbleiterspeicher nach Anspruch 4, 5, 6 oder 7, dadurch gekennzeichnet, daß die leitfähige Schicht (13) oder Schichten (13, 25) als eine Masseleitung für die Lade/Last-Speicherzelle mit polykristallinem Hochwiderstandsilizium dienen.

**Revendications**

1. Dispositif à semi-conducteurs comprenant :

   un transistor formé sur un substrat semi-conducteur (1), le transistor comportant une grille (7) ;
   un premier film isolant (12) formé sur le transistor ;
   une couche conductrice (13) formée au-dessus dudit film isolant et connectée à une source adaptée pour fournir un potentiel constant ;
   un second film isolant (14) formé sur ladite couche conductrice ; et
   un film de silicium polycristallin ou monocristallin (20) formé sur ledit second film isolant et comprenant deux régions, une région de faible résistance (15) servant comme câblage et une région de résistance élevée servant comme résistance (R2), caractérisé en ce que la couche conductrice (13) est disposée sensiblement sous la région de résistance élevée (22) entre la région de résistance élevée et ladite grille (7) et recouvre une surface plus grande que la région de résistance élevée de manière à protéger totalement la région de résistance élevée des effets de champ du transistor disposé sous la couche conductrice.

2. Dispositif à semi-conducteurs selon la revendication 1, caractérisé en ce que ladite couche conductrice (13) est composée d'une ou de plus de deux substances parmi l'aluminium, le silicium polycristallin et les métaux réfractaires, tels que Mo, Ti et W, ou les siliciures métalliques réfractaires.

3. Dispositif à semi-conducteurs selon la revendication 1, caractérisé en ce que la couche conductrice (13) est mise à la masse.

4. Mémoire à semi-conducteurs comprenant :
   une cellule de mémoire comprenant un élément de chargement comprenant du silicium polycristallin de résistance élevée et comprenant un dispositif à semi-conducteurs selon la revendication 1.

5. Mémoire à semi-conducteurs selon la revendication 4, comprenant une autre couche conductrice (25) connectée à un potentiel constant disposé sur le côté opposé de la résistance (R2) par rapport au substrat semi-conducteur et comprenant un film isolant (24) disposé entre ladite autre couche conductrice et ladite résistance élevée.

6. Mémoire à semi-conducteurs selon la revendication 4 ou 5, caractérisée en ce que ladite couche (13) ou lesdites couches conductrices (13, 25) sont composées d'une ou de plus de deux substances parmi l'aluminium, le silicium polycristallin et les métaux réfractaires, tels que Mo, Ti et W, ou les siliciures métalliques réfractaires.

7. Mémoire à semi-conducteurs selon la revendication 4, 5 ou 6, caractérisée en ce que ladite couche (13) ou lesdites couches conductrices (13, 25) sont mises à la masse.

8. Mémoire à semi-conducteurs selon la revendication 4, 5, 6 ou 7, caractérisée en ce que ladite couche (13) ou lesdites couches conductrices (13, 25) servent comme conducteur de mise à la masse pour ladite cellule de mémoire de type à chargement par silicium polycristallin de résistance élevée.

Fig. 1

Fig. 2

Fig. 3

Fig. 4 (a)

Fig 4(b)

(a)

Fig. 5

(b)

Fig. 5

(c)

Fig. 5

Fig. 6

Fig. 7

Fig. 8

Fig. 9

Fig-10.